# EUROPEAN PATENT APPLICATION

(11) **EP 3 054 592 A1**
(43) Date of publication of application: **10.08.2016**
(21) Application number: 15154300.6
(22) Date of filing: 09.02.2015
(51) Int. Cl.: H03H 7/42, H02M 3/10, H02M 3/158, H02J 7/34, H02M 3/02, H01F 27/245, H01F 27/28, H01F 3/10, H01F 38/02

(54) **MAGNETOELECTRIC DEVICE CAPABLE OF STORING USABLE ELECTRICAL ENERGY**

(71) Applicant: Hsu, Fu-Tzu, Taipei City 10463 (TW); Tu, Chieh-Sen, New Taipei City 23158 (TW)
(72) Inventor: Hsu, Fu-Tzu, 10463 Taipei City (TW)
(74) Representative: Zimmermann, Tankred Klaus

(57) **Abstract**

A magnetoelectric device includes at least one reluctance component (2), at least one damping capacitor (C_{d}), and a switching circuit (S1, S2). The reluctance component (2) includes a capacitive and inductive magnetic core unit (21) having a loop-shaped first segment (22) and a second segment (23) connected to the first segment, and at least one coil (L) wound around and loosely coupled to the magnetic core unit (21). The damping capacitor (C_{d}) cooperates with the coil (L) to form a resonant circuit. The switching circuit (S1, S2) makes and breaks electrical connection between the coil and a DC power source (V_{dc}) so that an eddy current flowing through the resonant circuit may be generated for storing energy in the damping capacitor (C_{d}). The second segment (23) may be a permanent magnet. The damping capacitor outputs current to charge the DC power source (V_{dc}) when the voltage across the damping capacitor exceeds that of the DC power source (V_{dc}). In such a manner, magnetic energy of the magnetic core unit that has positive magnetic damping effect is converted into electrical energy for output, such that output electrical energy is increased, thus promoting usable electrical energy stored in the DC power source (V_{dc}).

## Description

The invention relates to an electric device, and more particularly to a magnetoelectric device.

Figure 1 shows a conventional transformer 1 that is disclosed in Taiwan patent No. I270900 and that includes an E-shaped magnetic core and an I-shaped magnetic core. A primary coil 11 and a secondary coil 12 are wound around and tightly coupled to the E-shaped magnetic core. In general, the conventional magnetic core is made of a single material, such that there must be an air gap between the magnetic cores for preventing magnetic saturation, resulting in negative magnetic damping effect and limiting output electrical energy. In addition, the counter-electromotive force at the output terminal OUT may directly impact the input terminal, resulting in great loss of eddy current. As a result, even if the conventional transformer 1 has high conversion efficiency, it can only be used for transmission or transfer of electrical energy.

Therefore, an object of the present invention is to provide a magnetoelectric device that has positive magnetic damping effect and that may store usable electrical energy.

According to the present invention, a magnetoelectric device comprises:
at least one reluctance component that includes a magnetic core unit and at least one coil, the magnetic core unit having a loop-shaped first segment and a second segment connected to the first segment, and being made of a magnetic core material such that the magnetic core unit is both capacitive and inductive, the at least one coil being wound around and loosely coupled to the magnetic core unit;
at least one damping capacitor coupled to and cooperating with the at least one coil to form a resonant circuit; and
a switching circuit disposed to couple the at least one coil to a direct-current (DC) power source, and operable to make electrical connection between the at least one coil and the DC power source for exciting the at least one coil such that the magnetic core unit reaches magnetic saturation, and to subsequently break electrical connection between the at least one coil and the DC power source so as to generate an eddy current flowing through the resonant circuit for storing energy in the damping capacitor.

Other features and advantages of the present invention will become apparent in the following detailed description of the preferred embodiments with reference to the accompanying drawings, of which:
Figure 1 is a schematic diagram showing a conventional transformer;
Figure 2 is a schematic diagram showing a reluctance component of a first preferred embodiment of the magnetoelectric device according to the present invention;
Figure 3 is a schematic circuit diagram illustrating the first preferred embodiment of the magnetoelectric device according to the present invention;
Figures 4 and 5 are schematic circuit diagrams illustrating operation of the first preferred embodiment of the magnetoelectric device;
Figure 6 is a schematic diagram showing a modification of the reluctance component of the first preferred embodiment;
Figure 7 is an exploded schematic diagram of a magnetic core unit of a reluctance component of a second preferred embodiment of the magnetoelectric device according to the present invention;
Figure 8 is a perspective view of the reluctance component of the second preferred embodiment;
Figure 9 is a schematic circuit diagram illustrating the second preferred embodiment of the magnetoelectric device according to the present invention;
Figures 10 to 13 are schematic circuit diagrams illustrating operation of the second preferred embodiment of the magnetoelectric device;
Figure 14 is an exploded schematic diagram of a magnetic core unit of a reluctance component of a third preferred embodiment of the magnetoelectric device according to the present invention;
Figure 15 is a perspective view of the reluctance component of the third preferred embodiment;
Figure 16 is a schematic circuit diagram illustrating a third preferred embodiment of the magnetoelectric device according to the present invention; and
Figures 17 and 18 are schematic circuit diagrams illustrating operation of the third preferred embodiment of the magnetoelectric device.

The magnetoelectric device according to the present invention promotes usable electrical energy by switching control of current flow through a reluctance component that has positive magnetic damping effect. The reluctance component used in this invention includes a magnetic core unit and at least one coil. The magnetic core unit has a loop-shaped first segment and a second segment connected to the first segment, and is made of at least one magnetic core material such that the magnetic core unit is both capacitive and inductive. Said at least one coil is wound around and loosely coupled to the magnetic core unit.

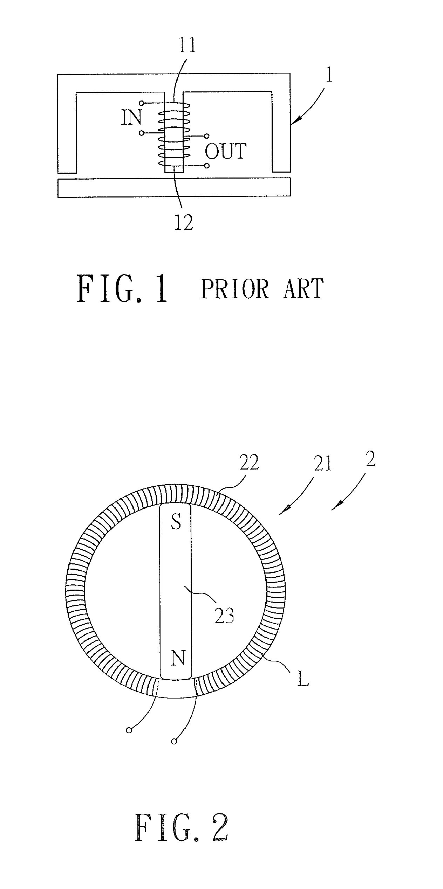

Figure 2 shows a reluctance component 2 of a first preferred embodiment of the magnetoelectric device. The first segment of the magnetic core unit 21 is a PN-type semiconductor magnetic core 22 that is both capacitive and inductive (e.g., a solid state inductor), and the second segment of the magnetic core unit 21 is a permanent magnet 23 surrounded by the magnetic core 22 and having opposite ends respectively adjacent to oppositely disposed parts of the magnetic core 22. The coil L is wound around the magnetic core 22. Since the coil L is loosely coupled to the magnetic core 22, since there is no air gap between the magnetic core 22 and the permanent magnet 23, and since the permanent magnet 23 has negative impedance (negative inductance) effect, the magnetic core unit 21 rapidly reaches magnetic saturation when the coil L is excited with current to generate a magnetic field that magnetizes the magnetic core unit 21, and when provision of the current to the coil L is subsequently stopped, the magnetic core unit 21 releases magnetic energy as a result of positive magnetic damping effect (i.e., magnetic shunt), and generates an eddy current that flows to the coil L, and the electrical energy outputted by the coil L is increased as a consequence.

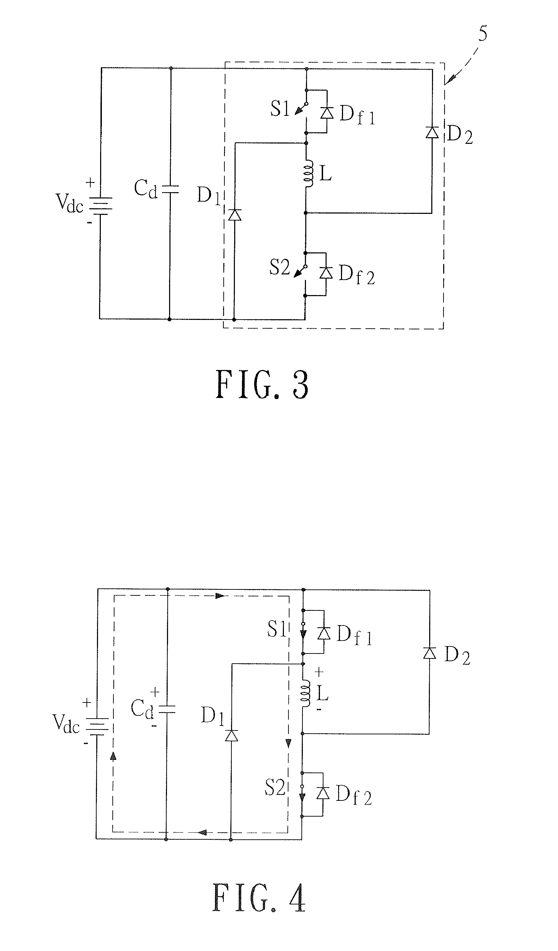

Referring to Figure 3, the first preferred embodiment of the magnetoelectric device according to the present invention receives input of a direct-current (DC) power source V_{dc} (e.g., a rechargeable battery), and includes the reluctance component 2 (see Figure 2), a damping capacitor C_{d} coupled to the DC power source V_{dc} in parallel, and a switching circuit 5. The switching circuit 5 includes a first switch S1 coupled between a terminal of the coil L and a positive terminal of the DC power source V_{dc}, a second switch S2 coupled between another terminal of the coil L and a negative terminal of the DC power source V_{dc}, a first diode D₁ having a cathode coupled to the terminal of the coil L, and an anode coupled to the negative terminal of the DC power source V_{dc}, a second diode D₂ having an anode coupled to said another terminal of the coil L, and a cathode coupled to the positive terminal of the DC power source V_{dc}, a first freewheeling diode D_{f1} coupled to the first switch S1 in parallel and having a cathode coupled to the positive terminal of the DC power source V_{dc}, and a second freewheeling diode D_{f2} coupled to the second switch S2 in parallel and having an anode coupled to the negative terminal of the DC power source V_{dc}.

It should be noted that a switch controller (not shown) may be included in the switching circuit 5 to control the switches throughout all of the preferred embodiments of the magnetoelectric device according to this invention. However, the switches may be controlled externally in other embodiments.

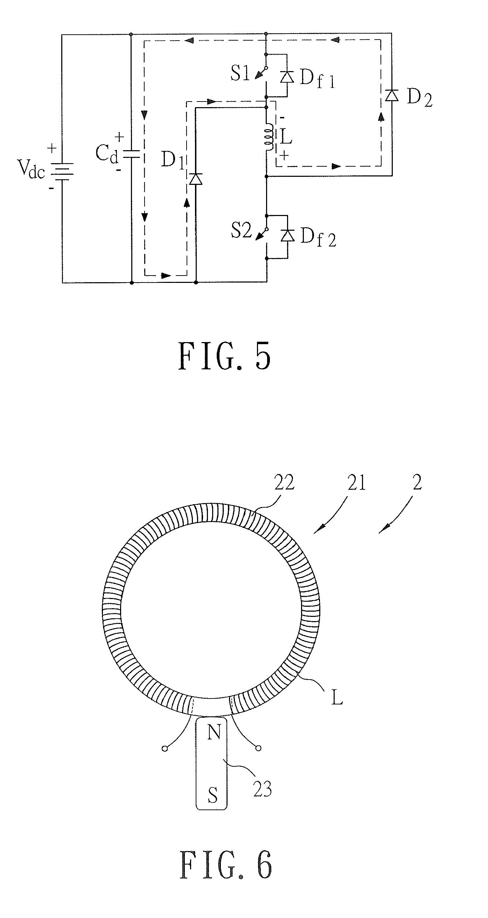

Referring to Figure 4, when the first and second switches S1, S2 are closed (i.e., make electrical connections) simultaneously, the DC power source V_{dc} is coupled to the coil L through the switches S1, S2, current outputted by the DC power source V_{dc} flows through and excites the coil L, and a magnetic field is thus generated to magnetize the magnetic core unit 21, such that the magnetic core unit 21 reaches magnetic saturation rapidly and becomes a magnet instantly. Then, as shown in Figure 5, the switches S1, S2 are switched to be open (i.e., break electrical connections) simultaneously such that the coil L is coupled to the damping capacitor C_{d} through the diodes D₁, D₂, thereby cooperatively forming a resonant circuit. At this time, in addition to current generated by the coil L due to counter-electromotive force, the magnetic core unit 21 is demagnetized in a very short time due to magnetic shunt, and generates an eddy current coupled to the coil L, such that the coil L outputs a current (including the eddy current and the current generated due to counter-electromotive force) that charges the damping capacitor C_{d}.

Therefore, by repeated control of the switches S1, S2 to take turns in making electrical connections simultaneously and breaking electrical connections simultaneously, the damping capacitor C_{d} eventually charges the DC power source V_{dc} when a voltage across the damping capacitor C_{d} is higher than that of the DC power source V_{dc}, promoting usable electrical energy stored in the DC power source V_{dc}. In this embodiment, the switches S1, S2 are controlled using a control signal with a constant frequency of about 10KHz and an amplitude of about 12V, but the present invention should not be limited in this respect. In addition, a time point at which the magnetic core unit 21 reaches magnetic saturation may be controlled by adjustment of a duty cycle of the control signal, such that the eddy current may be maximized.

In a modification, in this embodiment, the magnetic core unit 21 may be configured such that the permanent magnet 23 has one end adjacent to an outer periphery of the magnetic core 22, as shown in Figure 6, instead of the configuration as shown in Figure 2. In such a configuration, the magnetic core unit 21 can also reach magnetic saturation rapidly when the coil L is excited.

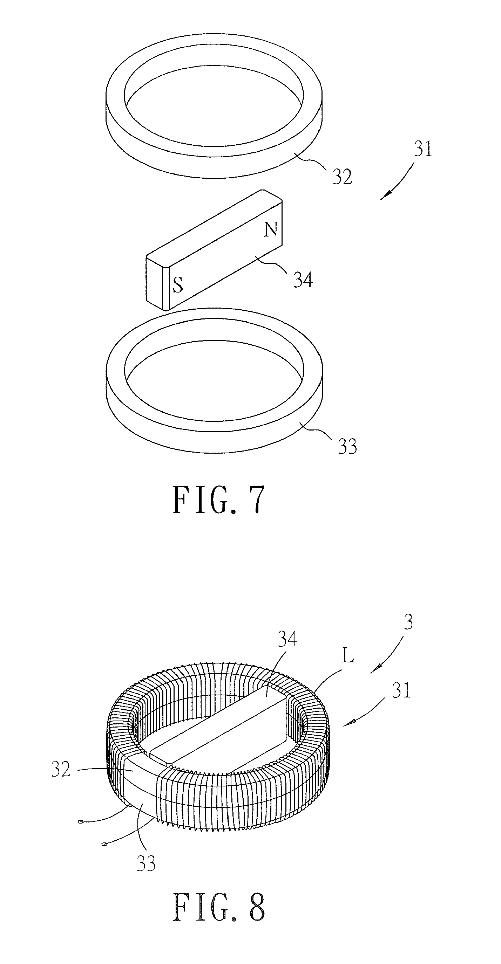

Figures 7 and 8 show a magnetic core unit 31 and a coil L of the reluctance component 3 of a second preferred embodiment of the magnetoelectric device. The magnetic core unit 31 includes a loop-shaped inductive Mn-Zn magnetic core 32 and a loop-shaped capacitive Ni-Zn magnetic core 33 that are arranged in a stack to serve as the first segment of the magnetic core unit 31. The second segment of the magnetic core unit 31 is a permanent magnet 34 surrounded by the first segment of the magnetic core unit 31 and having opposite ends respectively adjacent to oppositely disposed parts of the first segment. The coil L is wound around the first segment of the magnetic core unit 31. Since the coil L is loosely coupled to the magnetic core unit 31, since there is no air gap between the first segment of the magnetic core unit 31 and the permanent magnet 34, and since the permanent magnet 34 has negative impedance (negative inductance) effect, the magnetic core unit 31 rapidly reaches magnetic saturation when the coil L is excited with current to generate a magnetic field that magnetizes the magnetic core unit 31, and when provision of the current to the coil L is subsequently stopped, the magnetic core unit 31 releases magnetic energy as a result of magnetic shunt, and generates an eddy current that flows to the coil L, and the electrical energy outputted by the coil L is increased as a consequence.

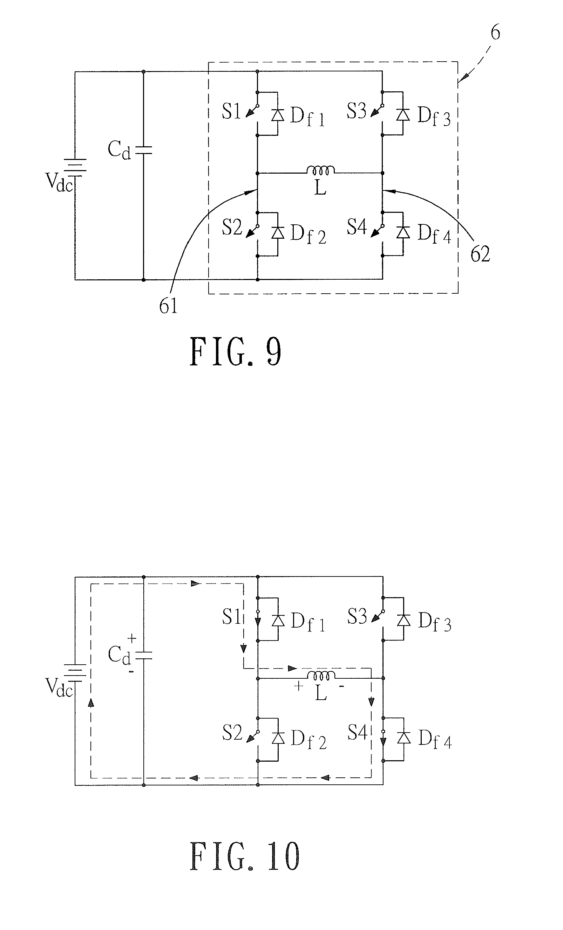

Referring to Figure 9, the second preferred embodiment of the magnetoelectric device according to the present invention receives input of a DC power source V_{dc} (e.g., a rechargeable battery), and includes the reluctance component 3 (see Figure 8), a damping capacitor C_{d} coupled to the DC power source V_{dc} in parallel, and a switching circuit 6. The switching circuit 6 includes two bridge arms 61, 62. Each of the bridge arms 61, 62 is coupled to the DC power source V_{dc} in parallel, and includes a first switch S1/S3, a second switch S2/S4, a first freewheeling diode D_{f1}/D_{f3}, and a second freewheeling diode D_{f2}/D_{f4}. The first switch S1/S3 has a terminal coupled to a positive terminal of the DC power source V_{dc}. The second switch S2/S4 is coupled between another terminal of the first switch S1/S3 and a negative terminal of the DC power source V_{dc}. The first freewheeling diode D_{f1}/D_{f3} is coupled to the first switch S1/S3 in parallel, and has a cathode coupled to the positive terminal of the DC power source V_{dc}. The second freewheeling diode D_{f2}/D_{f4} is coupled to the second switch S2/S4 in parallel, and has an anode coupled to the negative terminal of the DC power source V_{dc}. The coil L is coupled between common nodes of the first switch S1/S3 and the second switch S2/S4 of the two bridge arms 61, 62.

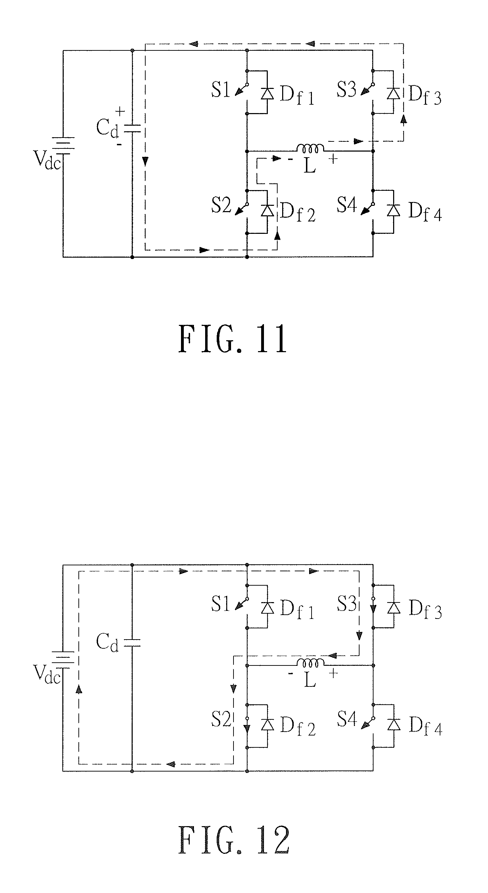

Referring to Figure 10, when the switches S1, S4 are closed, and the switches S2, S3 are open, the DC power source V_{dc} is coupled to the coil L through the switches S1, S4, current outputted by the DC power source V_{dc} flows through and excites the coil L, and a magnetic field is thus generated to magnetize the magnetic core unit 31, such that the magnetic core unit 31 reaches magnetic saturation rapidly and becomes a magnet instantly. Then, as shown in Figure 11, the switches S1, S4 are switched to be open such that the coil L is coupled to the damping capacitor C_{d} through the freewheeling diodes D_{f2}, D_{f3}, thereby cooperatively forming a resonant circuit. At this time, in addition to current generated by the coil L due to counter-electromotive force, the magnetic core unit 31 is demagnetized in a very short time due to magnetic shunt, and generates an eddy current coupled to the coil L, such that the coil L outputs a current (including the eddy current and the current generated due to counter-electromotive force) that charges the damping capacitor C_{d}.

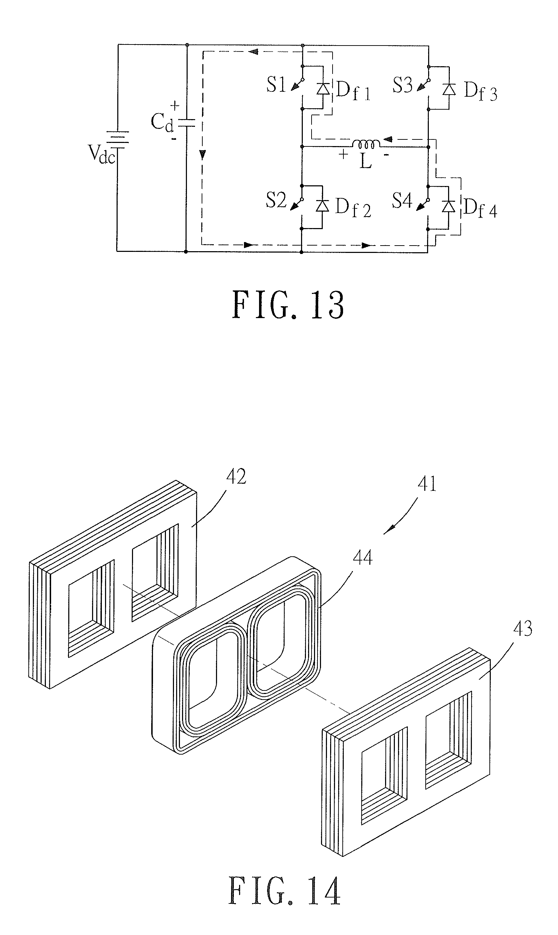

Similarly, referring to Figure 12, when the switches S2, S3 are closed, and the switches S1, S4 are open, the DC power source V_{dc} is coupled to the coil L through the switches S2, S3, current outputted by the DC power source V_{dc} flows through and excites the coil L, and a magnetic field is thus generated to magnetize the magnetic core unit 31, such that the magnetic core unit 31 reaches magnetic saturation rapidly and becomes a magnet instantly. Then, as shown in Figure 13, the switches S2, S3 are switched to be open such that the coil L is coupled to the damping capacitor C_{d} through the freewheeling diodes D_{f1}, D_{f4}, thereby cooperatively forming a resonant circuit. At this time, in addition to current generated by the coil L due to counter-electromotive force, the magnetic core unit 31 is demagnetized in a very short time due to magnetic shunt, and generates an eddy current coupled to the coil L, such that the coil L outputs a current (including the eddy current and the current generated due to counter-electromotive force) that charges the damping capacitor C_{d}.

Therefore, when a control signal is provided such that the switches S1, S4 and the switches S2, S3 take turns in making electrical connections, the magnetic core unit 31 keeps on generating the eddy current coupled to the coil L due to repeatedly being magnetized and demagnetized, and charging the damping capacitor C_{d}, such that the damping capacitor C_{d} eventually charges the DC power source V_{dc} when a voltage across the damping capacitor C_{d} is higher than that of the DC power source V_{dc}, promoting usable electrical energy stored in the DC power source V_{dc}. In this embodiment, the control signal has a constant frequency of about 10KHz and an amplitude of about 12V, but the present invention should not be limited in this respect. In addition, a time point at which the magnetic core unit 31 reaches magnetic saturation may be controlled by adjustment of a duty cycle of the control signal, such that the eddy current may be maximized.

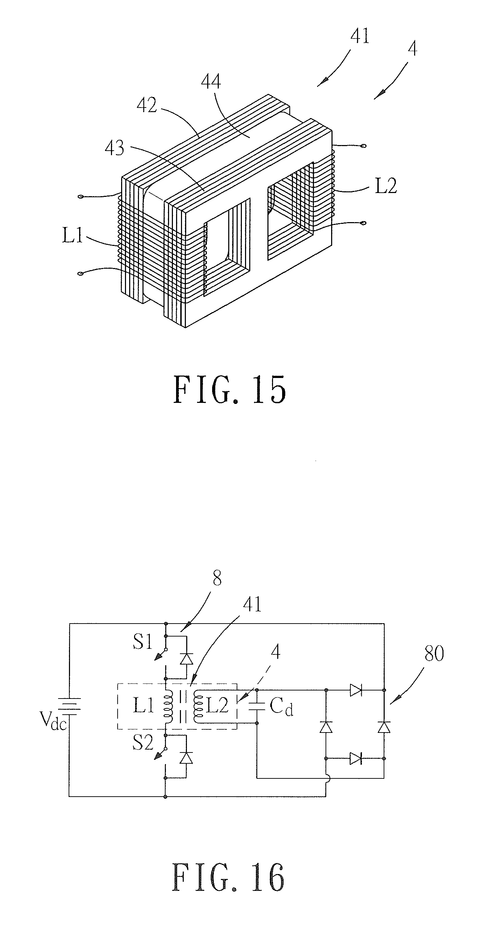

Figures 14 and 15 show a magnetic core unit 41, a first coil L1 and a second coil L2 of a reluctance component 4 of a third preferred embodiment of the magnetoelectric device. In this embodiment, the second segment of the magnetic core unit 41 is surrounded by the first segment of the magnetic core unit 41 and extends between oppositely disposed parts of the first segment. The magnetic core unit 41 includes a first set of silicon steel sheets 42, a second set of silicon steel sheets 43, and an inductive amorphous magnetic core 44 sandwiched between the first set and the second set of silicon steel sheets 42, 43. The first coil L1 and the second coil L2 are respectively wound around and loosely coupled to first and second sections of the first segment of the magnetic core unit 41 that are disposed on opposite sides of the second segment of the magnetic core unit 41. Since the coils L1 and L2 are loosely coupled to the magnetic core unit 41, and since there is no air gap among the first set of silicon steel sheets 42, the second set of silicon steel sheets 43 and the amorphous magnetic core 44, the magnetic core unit 41 rapidly reaches magnetic saturation when the first coil L1 is excited with current to generate a magnetic field that magnetizes the magnetic core unit 41, and when provision of the current to the first coil L1 is subsequently stopped, the magnetic core unit 41 is demagnetized in a very short time, resulting in positive magnetic damping effect (magnetic shunt), and generates an eddy current that flows to the second coil L2 as a result of release of magnetic energy, such that the electrical energy outputted by the second coil L2 is increased as a consequence.

Referring to Figure 16, a third preferred embodiment of the magnetoelectric device according to the present invention receives input of a DC power source V_{dc} (e.g., a rechargeable battery), and includes the reluctance component 4 (see Figure 15), a damping capacitor C_{d} coupled to the second coil L2 in parallel, a switching circuit 8, and a full-wave rectifier circuit 80 coupling the damping capacitor C_{d} to positive and negative terminals of the DC power source V_{dc}. The switching circuit 8 includes a first switch S1 coupled between an end of the first coil L1 and the positive terminal of the DC power source V_{dc}, and a second switch S2 coupled between another end of the first coil L1 and the negative terminal of the DC power source V_{dc}.

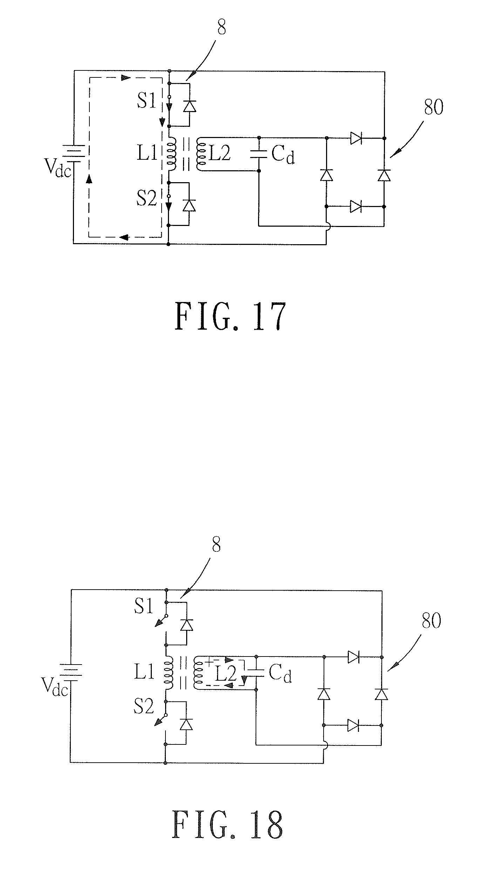

Referring to Figure 17, when the first switch S1 and the second switch S2 are closed, the DC power source V_{dc} is coupled to the first coil L1 through the first switch S1 and the second switch S2, current outputted by the DC power source V_{dc} flows through and excites the first coil L1, and a magnetic field is thus generated by the first coil L1 to magnetize the magnetic core unit 41, such that the magnetic core unit 41 reaches magnetic saturation rapidly and becomes a magnet instantly. Then, as shown in Figure 18, the first switch S1 and the second switch S2 are simultaneously switched to be open such that the magnetic core unit 41 is demagnetized in a very short time, and an eddy current generated by the magnetic core unit 41 due to magnetic shunt is coupled to the second coil L2 and charges the damping capacitor C_{d}.

Therefore, when a control signal is provided such that the switches S1, S2 repeatedly alternate between making electrical connections simultaneously and breaking electrical connections simultaneously, the magnetic core unit 41 keeps on generating the eddy current coupled to the second coil L2 due to repeatedly being magnetized and demagnetized, and charging the damping capacitor C_{d} through the second coil L2. In this embodiment, the control signal has a constant frequency, and when amplitude of the control signal is adjusted such that the second coil L2 cooperates with the damping capacitor Cd to be resonant, a sine-wave resonance signal is generated on the damping capacitor C_{d}. The full-wave rectifier circuit 80 rectifies the sine-wave resonance signal into a pulsating DC signal for charging the DC power source V_{dc}, thereby promoting usable electrical energy stored in the DC power source V_{dc}.

To sum up, the preferred embodiments of this invention use different control signals to control the abovementioned switching circuits, making electrical connection(s) between the DC power source V_{dc} and the coil(s) wound around the magnetic core unit(s) of the reluctance component to magnetize the magnetic core unit(s), and subsequently breaking electrical connection(s) between the DC power source V_{dc} and the coil(s), to thereby demagnetize the magnetic core unit(s) as a result of magnetic shunt, and to generate an eddy current coupled to the coil (s) wound around the magnetic core unit(s) for charging the damping capacitor(s). Then, the damping capacitor(s) outputs current to charge the DC power source V_{dc} when the voltage across the damping capacitor(s) exceeds that of the DC power source V_{dc}. In such a manner, magnetic energy of the magnetic core unit that has positive magnetic damping effect is converted into electrical energy for output, such that output electrical energy is increased, thus promoting usable electrical energy stored in the DC power source V_{dc}.

## Claims

1. A magnetoelectric device **characterized by**:
at least one reluctance component (2, 3, 4) that includes a magnetic core unit (21, 31, 41) and at least one coil, said magnetic core unit (21, 31, 41) having a loop-shaped first segment and a second segment connected to said first segment, and being made of a magnetic core material such that said magnetic core unit (21, 31, 41) is both capacitive and inductive, said at least one coil being wound around and loosely coupled to said magnetic core unit(21, 31, 41);
at least one damping capacitor (C_{d}) coupled to and cooperating with said at least one coil to form a resonant circuit; and
a switching circuit (5, 6, 8) disposed to couple said at least one coil to a direct-current (DC) power source (V_{dc}), and operable to make electrical connection between said at least one coil and the DC power source (V_{dc}) for exciting said at least one coil such that said magnetic core unit (21, 31, 41) reaches magnetic saturation, and to subsequently break electrical connection between said at least one coil and the DC power source (V_{dc}) so as to generate an eddy current flowing through said resonant circuit for storing energy in said damping capacitor (C_{d}).

2. The magnetoelectric device as claimed in Claim 1, **characterized in that** said first segment of said magnetic core unit (21) is a PN-type semiconductor magnetic core (22) that is both capacitive and inductive, and said second segment of said magnetic core unit (21) is a permanent magnet (23) surrounded by said first segment of said magnetic core unit (21) and having opposite ends respectively adjacent to oppositely disposed parts of said first segment, said at least one coil including one coil (L) wound around said first segment of said magnetic core unit (21).

3. The magnetoelectric device as claimed in Claim 1, **characterized in that** said first segment of said magnetic core unit (21) is a PN-type semiconductor magnetic core (22) that is both capacitive and inductive, and said second segment of said magnetic core unit is a permanent magnet (23) having one end adjacent to an outer periphery of said first segment of said magnetic core unit (21), said at least one coil including one coil (L) wound around said first segment of said magnetic core unit (21).

4. The magnetoelectric device as claimed in Claim 2 or 3, further **characterized in that** said switching circuit (5) includes a first switch (S1), a second switch (S2), a first diode (D₁), and a second diode (D₂),
said first switch (S1) being disposed to couple a terminal of said coil (L) to a positive terminal of the DC power source (V_{dc}),
said second switch (S2) being disposed to couple another terminal of said coil (L) to a negative terminal of the DC power source (V_{dc}),
said first diode (D₁) having a cathode coupled to said terminal of said coil (L), and an anode to be coupled to the negative terminal of the DC power source (V_{dc}),
said second diode (D₂) having an anode coupled to said another terminal of said coil (L), and a cathode to be coupled to the positive terminal of the DC power source (V_{dc}) ; and
wherein said switching circuit (5) is operable such that said first switch (S1) and said second switch (S2) make electrical connections simultaneously and break electrical connections simultaneously.

5. The magnetoelectric device as claimed in any one of Claims 2 to 4, further **characterized in that** said PN-type semiconductor magnetic core (22) is a solid state inductor.

6. The magnetoelectric device as claimed in Claim 1, **characterized in that** said first segment of said magnetic core unit (31) includes a loop-shaped inductive Mn-Zn magnetic core (32) and a loop-shaped capacitive Ni-Zn magnetic core (33) that are arranged in a stack, and said second segment of said magnetic core unit (31) is a permanent magnet (34) surrounded by said first segment of said magnetic core unit (31) and having opposite ends respectively adjacent to oppositely disposed parts of said first segment, said at least one coil including one coil (L) wound around said first segment of said magnetic core unit (31).

7. The magnetoelectric device as claimed in Claim 6, further **characterized in that** said switching circuit (6) includes two bridge arms (61, 62), each to be coupled to the DC power source (V_{dc}) in parallel, and each including:
a first switch (S1, S3) having a terminal to be coupled to a positive terminal of the DC power source (Vdc) ;
a second switch (S2, S4) disposed to couple another terminal of said first switch (S1, S3) to a negative terminal of the DC power source (V_{dc}) ;
a first freewheeling diode (D_{f1}, D_{f3}) coupled to said first switch (S1, S3) in parallel, and having a cathode to be coupled to the positive terminal of the DC power source (V_{dc}) ; and
a second freewheeling diode (D_{f2}, D_{f4}) coupled to said second switch (S2, 24) in parallel, and having an anode to be coupled to the negative terminal of the DC power source (V_{dc}) ;
wherein said coil (L) is coupled between common nodes of said first switch (S1, S3) and said second switch (S2, S4) of said two bridge arms (61, 62); and
wherein said switching circuit is operable such that said first switch (S1, S3) of one of said bridge arms (61, 62) and said second switch (S4, S2) of the other one of said bridge arms (62, 61) both break electrical connections when said second switch (S2, S4) of said one of said bridge arms (61, 62) and said first switch (S3, S1) of the other one of said bridge arms (62, 61) both make electrical connections.

8. The magnetoelectric device as claimed in Claim 1, **characterized in that** said second segment of said magnetic core unit (41) is surrounded by said first segment of said magnetic core unit (41) and extends between oppositely disposed parts of said first segment,
wherein said magnetic core unit (41) includes a first set of silicon steel sheets (42), a second set of silicon steel sheets (43), and an inductive amorphous magnetic core (44) sandwiched between said first set and said second set of silicon steel sheets (42, 43); and
wherein said at least one coil includes a first coil (L1) and a second coil (L2) that are respectively wound around and loosely coupled to first and second sections of said first segment of said magnetic core unit (41) that are disposed on opposite sides of said second segment of said magnetic core unit (41).

9. The magnetoelectric device as claimed in Claim 8, further **characterized by** a full-wave rectifier circuit (80) disposed to couple said damping capacitor (C_{d}) to positive and negative terminals of the DC power source (V_{dc}), said damping capacitor (C_{d}) and said second coil (L2) being electrically coupled in parallel to form said resonant circuit, said switching circuit (8) including:
a first switch (S1) disposed to couple an end of said first coil (L1) to the positive terminal of the DC power source (V_{dc}) ;
a second switch (S2) disposed to couple another end of said first coil (L1) to the negative terminal of the DC power source (V_{dc});
a first diode coupled to said first switch (S1) in parallel and having an anode coupled to said end of said first coil (L1) ; and
a second diode coupled to said second switch (S2) in parallel and having a cathode coupled to said another end of said first coil (L1) ;
wherein said switching circuit (8) is operable such that said first switch (S1) and said second switch (S2) make electrical connections simultaneously and break electrical connections simultaneously.
